# EUROPÄISCHE PATENTSCHRIFT

(11) **EP 2 985 358 B1**
(45) Veröffentlichungstag und Bekanntmachung des Hinweises auf die Patenterteilung: **03.05.2017**
(21) Anmeldenummer: 14181001.0
(22) Anmeldetag: 14.08.2014
(51) Int. Cl.: C22C 21/00, C22F 1/04

(54) **Gleitlagerverbundwerkstoff**
Friction bearing composite material
Matériau composite de coussinet

(43) Veröffentlichungstag der Anmeldung: 17.02.2016
(73) Patentinhaber: KS Gleitlager GmbH, 68789 St. Leon-Rot (DE)
(72) Erfinder: Bürkle, Gunter, 71726 Benningen (DE); Witt, Mario, 69120 Heidelberg (DE); Kyrsta, Stepan, 52072 Aachen (DE)
(74) Vertreter: DREISS Patentanwälte PartG mbB

(56) Entgegenhaltungen:
- EP-A1- 2 518 172
- DE-A1- 10 149 675
- DE-A1-102005 023 541

## Beschreibung

Die Erfindung betrifft ein Verfahren zum Herstellen eines Gleitlagerverbundwerkstoffs mit einer Stützschicht, insbesondere aus Stahl, mit einer Lagermetallschicht aus einer Magnesium umfassenden Aluminiumbasislegierung und mit einer Laufschicht. Ferner betrifft die Erfindung einen solchen Gleitlagerverbundwerkstoff und ein hieraus hergestelltes Gleitlagerelement.

Derartige Gleitlagerverbundwerkstoffe sind bekannt. Typische Anwendungen finden sich im Bereich der Kraftfahrzeugtechnik, typischerweise im verbrennungsmotornahen Bereich, beispielsweise bei der Herstellung von Kurbelwellenlagerschalen und/oder Pleuellagerschalen.

Typische Gleitlagerverbundwerkstoffe weisen eine Stützschicht aus Stahl auf, welche die mechanische Stabilität und Formhaltigkeit des Gleitlagerverbundwerkstoffs garantiert. Auf der Stützschicht ist typischerweise eine Lagermetallschicht aufgebracht, welche insbesondere auf die Stützschicht aufgesintert, aufplattiert oder aufgegossen ist. Auf der Lagermetallschicht ist häufig eine Laufschicht angeordnet. In der Gleitlageranwendung ist die Laufschicht eines aus dem Gleitlagerverbundwerkstoff bestehenden und in Biegerollverfahren umgeformten Gleitlagerelements in Kontakt mit einem Gleitpartner.

WO 2010/125026 A1 offenbart einen Gleitlagerverbundwerkstoff der eingangs genannten Art. Es wird vorgeschlagen für die Ausbildung der Lagermetallschicht eine aushärtbare Aluminiumbasislegierung mit einem vergleichsweise hohen Kupfergehalt von 3,5 bis 4,5 Gew.-% Kupfer und mit 0,1 bis 1,5 Gew.-% Magnesium zu verwenden, um eine bevorzugte Härte von 70 bis 110 HV 0,01 (Vickershärte) zu erzielen. Dies ist durch den hohen Kupferanteil und anzunehmenderweise durch Lösungsglühen bei hohen Temperaturen und anschließendes Abschrecken realisierbar. Sowohl die Lagermetallschicht als auch eine darauf aufgebrachte Laufschicht sind walzplattiert und dementsprechend dick.

EP 0 672 840 A1 offenbart die Aufbringung einer dem Gleitpartner exponierten Laufschicht auf Aluminium-Zinn-Basis durch Walzplattieren auf eine Lagermetallschicht, wobei AlZn4SiPb, AlZn4, 5Mg, AlSi11CuMgNi und AlMgSi1 genannt sind. Der so erhaltene Walzplattierverbund wird in einem weiteren Walzplattierschritt auf eine Stützschicht aus Stahl aufgewalzt. Bei diesem Gleitlagerverbundwerkstoff, bei dem die aushärtbare Aluminiumlegierung eine Härte von 60 HV 0,5 aufwies, wurde das Problem beobachtet, dass diese Schicht bei starker Belastung axial aus der Lagerstelle herausgedrückt wurde. Hierauf reagierte die vorgenannte WO 2010/125026 A1 mit weiterer Aufhärtung durch Zulegierung hoher Kupfermengen.

EP 2 518 172 A1 offenbart ein Verfahren der eingangs genannten Art, wobei eine stranggegossene Aluminiumlegierung während mehrerer Kaltwalzprozesse bei 300-420°C weichgeglüht und bei Temperaturen von 420-450°C zur Bildung von Ausscheidungen geglüht wird und anschließend auf eine Stahlstützschicht walzplattiert wird. Hinweise auf weitere Wärmebehandlungen des so erhaltenen Verbunds lassen sich nicht entnehmen.

Der vorliegenden Erfindung liegt die Aufgabe zugrunde, einen Gleitlagerverbundwerkstoff zur Herstellung von Gleitlagerelementen zu schaffen, der gute Gleiteigenschaften und eine gute mechanische Stabilität und dauerhaft hohe Belastbarkeit aufweisen soll. Diese Eigenschaften sind insbesondere im Hinblick auf eine Verwendung in der modernen Kraftfahrzeugtechnik relevant, insbesondere in Fahrzeugen mit Start-/Stoppautomatik.

Diese Aufgabe wird erfindungsgemäß durch ein Verfahren zum Herstellen eines Gleitlagerverbundwerkstoffs mit den Merkmalen des Anspruchs 1 gelöst.

Vorteilhafterweise weist die Lagermetallschicht eine Schichtdicke von typischerweise 0,2 mm bis 0,8 mm auf. Die Stützschicht ist typischerweise mit einer Schichtdicke von 0,5 mm bis 4,0 mm ausgeführt. Die Dicke der metallischen Laufschicht beträgt höchstens 30 µm, insbesondere höchstens 25 µm, insbesondere höchstens 20 µm, und wenigstens 5 µm, insbesondere wenigstens 10 µm, insbesondere 10 - 20 µm.

Bei dem erfindungsgemäß hergestellten Gleitlagerverbundwerkstoff wurde überraschenderweise festgestellt, dass die Lagermetallschicht mit der erfindungsgemäßen Zusammensetzung und Behandlung eine ungewöhnlich hohe Dauerbelastbarkeit aufweist. Die Legierungszusammensetzung der Lagermetallschicht ist für die Verwendung in Gleitlagerverbundwerkstoffen daher vorteilhaft. Die durch die Erfindung gewährleistete eher moderate Härte der Lagermetallschicht in Verbindung mit der galvanischen oder in PVD-Verfahren aufgebrachten dünnen Laufschicht macht den Gleitlagerverbundwerkstoff ermüdungsfest und freßsicher und damit geeignet für verbrennungsmotornahe Anwendungen in der modernen Kfz-Technik, insbesondere für die Herstellung von Kurbelwellenlagerschalen und Pleuellagerschalen.

Es wurde erfindungsgemäß erkannt, dass eine starke Aufhärtung der Lagermetallschicht durch Zulegieren von Kupfer zu einer Versprödung führen kann, welche die Ermüdungsfestigkeit beeinträchtigen kann. Außerdem erweist sich die Verwendung von aushärtbaren Aluminiumbasislegierungen beim Walzplattieren als problematisch, wenn gleitpartnerseitig bereits eine weichere Laufschicht aufplattiert ist. Unter Anwendung des erfindungsgemäßen Verfahrens wird zunächst die Lagermetallschicht auf die Stützschicht aufgewalzt. Daran anschließend wird gerade kein Lösungsglühen bei hohen Temperaturen und anschließendem Abschrecken und Altern ausgeführt, sondern der so erhaltene Verbund wird bei Temperaturen zwischen 280° und 350°C, insbesondere zwischen 300° und 350°C weich geglüht. Hierbei bilden sich vergleichsweise große Ausscheidungen, typischerweise im Bereich von 1 - 10 µm, und es wird eine nur moderate Härte im beanspruchten Bereich realisiert. Dennoch hat es sich gezeigt, dass ein solchermaßen weichgeglühter Werkstoffverbund dauerhaft stabil und hochbelastbar bleibt und durch die nur moderate Härte eine geringe Empfindlichkeit gegen Schmutzpartikel im Ölstrom aufweist.

Der Magnesiumgehalt der Aluminiumbasislegierung beträgt vorteilhafterweise 1,5 - 5,5 Gew.-%, insbesondere 2,0 - 5,5 Gew.-%. Magnesium bleibt zumindest teilweise im Gitter gelöst und bildet teilweise Ausscheidungen. Durch die hierdurch erzielte Verspannung wird die moderate Härtung und damit eine Festigkeitssteigerung erzielt, die aber im weichgeglühten Zustand dauerhaft stabil ist. Da auf den so erhaltenen und behandelten Verbund die metallische Laufschicht galvanisch oder durch PVD-Verfahren und im Übrigen mit gegenüber Walzplattierverfahren geringer Dicke aufgebracht wird, wird das durch die erfindungsgemäße Verfahrensführung erhaltene Gefüge nicht weiter in Mitleidenschaft gezogen, sondern es behält seine auf erfindungsgemäße Weise eingestellten Eigenschaften. Es zeigte sich, dass auch eine dünne galvanische oder durch PVD-Verfahren, insbesondere Sputter-Verfahren, aufgebrachte Laufschicht auf Zinn- beziehungsweise Aluminiumbasis auf der erfindungsgemäß hergestellten Lagermetallschicht eine hohe Belastbarkeit und Dauerfestigkeit aufweist. Die so hergestellte Lagermetallschicht bildet also eine hervorragende Unterlage für die Laufschicht. Verquetschungen oder Herauspressungen, das heißt Fließen in axialer Richtung wurde auch unter höchsten Belastungen des erfindungsgemäß hergestellten Gleitlagerverbundwerkstoffs nicht beobachtet.

Bei einer vorteilhaften Ausführungsform des Gleitlagerverbundwerkstoffs ist die Aluminiumbasislegierung eine AlMg(2-3) - Legierung oder eine AlMg(3-4) - Legierung oder eine AlMg(4-5) - Legierung, gegebenenfalls mit 0,15-0,35 Gew.-% Cr und/oder 0,2-0,5 Gew.-% Mn, gegebenenfalls mit weiteren Legierungskomponenten die in der Summe 1 Gew.-% nicht übersteigen. Die angegebenen Zusammensetzungen der Aluminiumbasislegierung haben sich als besonders vorteilhaft für die Festigkeit und Verschleißbeständigkeit sowie Partikelverträglichkeit des erfindungsgemäßen Gleitlagerverbundwerkstoffs erwiesen. Je höher der Magnesiumanteil, desto höher ist die Festigkeit und Verschleißbeständigkeit; je geringer der Magnesiumanteil, desto höher ist die Partikelverträglichkeit.

Die mittels eines PVD-Verfahrens aufgebrachte Laufschicht ist vorteilhafterweise ebenfalls auf Aluminiumbasis ausgebildet und umfasst 5 - 40 Gew.-% Zinn und gegebenenfalls 0,1 - 5 Gew.-% Kupfer, 0,1 - 6 Gew.-% Silizium, 0,05 - 1,0 Gew.-% Mangan, 0,05 - 1 Gew.-% Chrom, 0,05 - 0,5 Gew.-% Titan, 0,05 - 0,5 Gew.-% Zirkonium, 0,05 - 0,5 Gew.-% Vanadium, 0,1 - 3 Gew.-% Nickel, 0,1 - 1 Gew.-% Kobalt und/oder 0,05 - 0,5 Gew.-% Cer umfasst. Eine Laufschicht, die mittels eines PVD-Verfahrens aufgebracht ist und insbesondere die vorstehende Zusammensetzung aufweist, hat sich als besonders belastbar und verschleißunempfindlich in Verbindung mit einer erfindungsgemäß hergestellten Lagermetallschicht herausgestellt.

Als besonders vorteilhaft hat sich ein Gleitlagerverbundwerkstoff erwiesen, bei dem die Laufschicht von einer AlSn(18-27)Cu(0,5-3)-Legierung, insbesondere von einer AlSn(20)Cu(1)-Legierung oder von einer AlSn(25)Cu(2,5)-Legierung ausgebildet ist und mittels eines PVD-Verfahrens aufgebracht ist. Eine solche Laufschicht weist aufgrund ihres hohen Zinngehalts vorteilhafte tribologische Eigenschaften auf. Durch den erfindungsgemäßen Kupfergehalt wird eine hohe Festigkeit der Laufschicht erreicht. Im Zusammenspiel mit der Lagermetallschicht des erfindungsgemäßen Gleitlagerverbundwerkstoffs wird hierdurch eine hohe Belastbarkeit des Gleitlagerverbundwerkstoffs erreicht.

Im Sinne der Erfindung ist ebenso, dass zwischen der Laufschicht und der Lagermetallschicht eine weitere, mittels eines PVD-Verfahrens aufgebrachte Schicht aus einer Aluminiumbasislegierung oder einer Kupfer-, Kobalt- oder Nickelbasislegierung angeordnet ist. Eine solche weitere Schicht kann als Diffusionssperre dienen und damit die Lebensdauer des erfindungsgemäßen Gleitlagerverbundwerkstoffs in der Anwendung erhöhen.

Im Sinne der Erfindung ist ebenso, dass die Laufschicht eine galvanisch abgeschiedene Schicht aus Wismut oder einer Wismutlegierung oder aus Zinn oder einer Zinn-Kupfer-Legierung, insbesondere aus einer SnCu(4-8)-Legierung, insbesondere aus einer SnCu(6)-Legierung ist. Eine solche Laufschicht weist gute Gleiteigenschaften bei gleichzeitig hoher Festigkeit und langer Lebensdauer auf. Galvanische Beschichtungen sind überdies kostengünstig und automatisiert realisierbar.
Im Sinne der Erfindung ist ebenso, dass zwischen einer solchen eben beschriebenen galvanisch abgeschiedenen Laufschicht und der Lagermetallschicht eine erste Zwischenschicht auf Nickel- oder Kupfer- oder Kobaltbasis angeordnet ist.

Im Sinne der Erfindung ist auch, dass zwischen der erfindungsgemäßen galvanisch abgeschiedenen Laufschicht und der ersten Zwischenschicht eine zweite Zwischenschicht auf Zinn-Nickel-Basis oder Zinn-Kupfer-Basis oder Zinn-Kobalt-Basis angeordnet ist. Eine solche zweite Zwischenschicht kann als Diffusionssperrschicht wirken und erhöht damit die Lebensdauer des Gleitlagerverbundwerkstoffs.

Die Zwischenschichten, die jeweils zwischen Lagermetallschicht und im PVD-Verfahren aufgebrachter oder galvanisch abgeschiedener Laufschicht angeordnet sein können, weisen typischerweise Schichtdicken zwischen 1 und 4 µm auf. Sie sind ebenfalls PVD-Verfahren oder galvanisch aufgebracht.

Es sei noch erwähnt, dass unter technischem Reinaluminium ein Werkstoff zu verstehen ist, der zu 99,5 Gew.-% aus Aluminium besteht und nur maximal 0,5 Gew.-% verunreinigungsbedingte Komponenten enthält.

Die dünne Laufschicht weist vorzugsweise eine Dicke von höchstens 30 µm, insbesondere von höchstens 25 µm, insbesondere von höchstens 20 µm, und von wenigstens 5 µm, insbesondere von wenigstens 10 µm, und weiter insbesondere von 10 - 20 µm auf.

Gegenstand der Erfindung ist auch ein Gleitlagerverbundwerkstoff, mit den Merkmalen des Anspruchs 11, der nach dem erfindungsgemäßen Verfahren hergestellt ist. Es wird auch Schutz beansprucht für einen Gleitlagerverbundwerkstoff, bei dem eine Lagermetallschicht der im Anspruch 11 erwähnten Zusammensetzung auf eine Stützschicht aufgewalzt ist und eine Brinell-Härte von 50 - 80 HB 1/5/30, insbesondere von 60 - 80 HB 1/5/30 aufweist, wobei auf diesem Verbund eine metallische Laufschicht einer Dicke von höchstens 30 µm galvanisch oder durch ein PVD-Verfahren entweder direkt auf die Lagermetallschicht oder auf eine oder mehrere sehr dünne Zwischenschichten einer Dicke von 1 bis 4 µm aufgebracht ist.

Im Sinne der Erfindung ist ebenso ein Gleitlagerelement, insbesondere eine Gleitlagerschale, insbesondere eine Kurbelwellenlagerschale oder eine Pleuellagerschale, die dadurch gekennzeichnet ist, dass sie den erfindungsgemäßen Gleitlagerverbundwerkstoff umfasst bzw. hieraus gefertigt ist. Die Verwendung eines solchen Gleitlagerelements bietet sich insbesondere für verbrennungsmotornahe Gleitlagerungsaufgaben in der modernen Kfz-Technik an. Hier entstehen, insbesondere bei modernen Hochleistungsmotoren mit Start-/Stoppautomatik Anwendungsfälle, welche hohe Anforderungen an tribologische sowie mechanische Eigenschaften der verwendeten Gleitlagerelemente stellen. Diese Anforderungen können durch die Verwendung des erfindungsgemäßen Gleitlagerelements, basierend auf dem erfindungsgemäßen Gleitlagerverbundwerkstoff, erfüllt werden.

Weitere Merkmale, Einzelheiten und Vorteile der Erfindung ergeben sich aus den beigefügten Patentansprüchen, der zeichnerischen Darstellung und nachfolgenden Beschreibung mehrerer bevorzugter Ausführungsformen des erfindungsgemäßen Gleitlagerverbundwerkstoff sowie des erfindungsgemäßen Gleitlagerelements.

In der Zeichnung zeigt:
- Figur 1: eine schematische, nicht maßstabsgetreue Schnittansicht eines erfindungsgemäßen Gleitlagerverbundwerkstoffs; und
- Figur 2: eine schematische, nicht maßstabsgetreue Schnittansicht einer weiteren Ausführungsform eines erfindungsgemäßen Gleitlagerverbundwerkstoffs; und
- Figur 3: eine schematische, nicht maßstabsgetreue Schnittansicht einer weiteren Ausführungsform eines erfindungsgemäßen Gleitlagerverbundwerkstoffs; und
- Figur 4: eine schematische, nicht maßstabsgetreue Schnittansicht einer Pleuellagerschale, die einen erfindungsgemäßen Gleitlagerverbundwerkstoff umfasst.

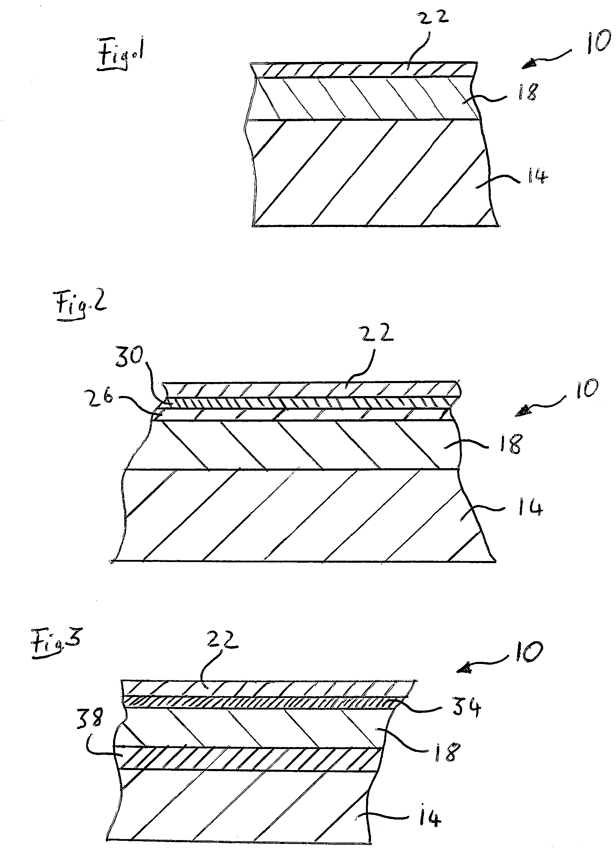

Figur 1 zeigt eine schematische, größenmäßig nicht skalierte Schnittansicht eines erfindungsgemäßen Gleitlagerverbundwerkstoffs 10 für die Herstellung von Gleitlagerelementen, insbesondere Gleitlagerschalen in einem Biegeprozess. Der Gleitlagerverbundwerkstoff 10 umfasst eine Stützschicht 14, vorzugsweise aus Stahl. Auf einer einem Gleitpartner zugewandten Seite der Stützschicht 14 ist eine Lagermetallschicht 18 mit der in der Beschreibungseinleitung genannten Zusammensetzung aufgewalzt also in einem Walzplattierverfahren aufgebracht. Auf die Lagermetallschicht 18 ist eine dünne Laufschicht 22 mit der in der Beschreibungseinleitung genannten Zusammensetzung und Dicke galvanisch oder in einem PVD-Verfahren aufgebracht.

Figur 2 zeigt eine schematische, größenmäßig nicht skalierte Schnittansicht eines erfindungsgemäßen Gleitlagerverbundwerkstoffs 10. In dem in Figur 2 gezeigten Ausführungsbeispiel ist die Laufschicht 22 als galvanisch abgeschiedene Schicht ausgeführt. In diesem Ausführungsbeispiel ist zwischen der Lagermetallschicht 18 und der Laufschicht 22 eine erste Zwischenschicht 26 mit der in der Beschreibungseinleitung genannten Zusammensetzung angeordnet. Zwischen der ersten Zwischenschicht 26 und der Laufschicht 22 ist eine zweite Zwischenschicht 30 mit der in der Beschreibungseinleitung genannten Zusammensetzung angeordnet. Beide Zwischenschichten sind galvanisch aufgebracht und haben eine geringe Dicke von vorzugsweise nur 1 - 4 µm.

Figur 3 zeigt eine schematisch dargestellte und größenmäßig nicht skalierte Schnittansicht eines erfindungsgemäßen Gleitlagerverbundwerkstoffs 10. In dem in Figur 3 dargestellten Ausführungsbeispiel ist die Laufschicht 22 als eine im PVD-Verfahren aufgebrachte, typischerweise gesputterte Schicht mit der in der Beschreibungseinleitung genannten Zusammensetzung ausgeführt. Zwischen der Laufschicht 22 und der Lagermetallschicht 18 ist eine weitere mittels eines PVD-Verfahrens aufgebrachte Schicht 34 mit der in der Beschreibungseinleitung genannten Zusammensetzung angeordnet.

Zwischen der Lagermetallschicht 18 und der Stützschicht 14 ist eine Zwischenschicht 38 angeordnet. Die Zwischenschicht 38 ist in diesem Ausführungsbeispiel in Form einer Aluminiumlegierung ausgeführt, kann jedoch im Sinne der Erfindung ebenso aus Reinaluminium ausgeführt sein. Im Sinne der Erfindung ist ebenso ein Schichtaufbau, der keine Zwischenschicht 38 aufweist. Zur Herstellung werden die Lagermetallschicht 18 und die Zwischenschicht 38 miteinander walzplattiert. Danach wird der Verbund aus Lagermetallschicht 18 und Zwischenschicht 38 auf die Stützschicht 14 aufplattiert, was problemlos möglich ist, weil die Zwischenschicht 38 weicher ist als die Lagermetallschicht 18.

In den in Figur 1 bis 3 gezeigten Ausführungsbeispielen bildet jeweils die Lagermetallschicht 18 mit ihrer erfindungsgemäßen Zusammensetzung eine feste Unterlage mit nur moderater Härte für die Laufschicht 22. Dieser Verbund erlaubt eine hohe Belastung der Laufschicht 22 bei gleichzeitig langer Lebensdauer des Gleitlagerverbundwerkstoffs 10.

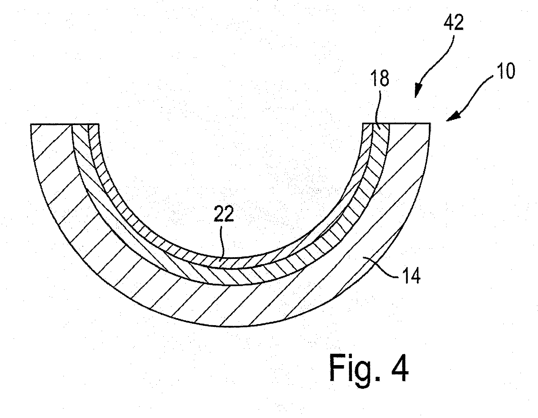

In Figur 4 ist eine schematisch dargestellte und größenmäßig nicht skalierte Schnittansicht einer erfindungsgemäßen Gleitlagerschale 42 gezeigt. Eine solche Gleitlagerschale kann aus dem erfindungsgemäßen Gleitlagerverbundwerkstoff 10 beispielsweise mittels Rollbiegen hergestellt werden. weitere mittels eines PVD-Verfahrens aufgebrachte Schicht 34 mit der in der Beschreibungseinleitung genannten Zusammensetzung angeordnet.

Zwischen der Lagermetallschicht 18 und der Stützschicht 14 ist eine Zwischenschicht 38 angeordnet. Die Zwischenschicht 38 ist in diesem Ausführungsbeispiel in Form einer Aluminiumlegierung ausgeführt, kann jedoch im Sinne der Erfindung ebenso aus Reinaluminium ausgeführt sein. Im Sinne der Erfindung ist ebenso ein Schichtaufbau, der keine Zwischenschicht 38 aufweist. Zur Herstellung werden die Lagermetallschicht 18 und die Zwischenschicht 38 miteinander walzplattiert. Danach wird der Verbund aus Lagermetallschicht 18 und Zwischenschicht 38 auf die Stützschicht 14 aufplattiert, was problemlos möglich ist, weil die Zwischenschicht 38 weicher ist als die Lagermetallschicht 18.

In den in Figur 1 bis 3 gezeigten Ausführungsbeispielen bildet jeweils die Lagermetallschicht 18 mit ihrer erfindungsgemäßen Zusammensetzung eine feste Unterlage mit nur moderater Härte für die Laufschicht 22. Dieser Verbund erlaubt eine hohe Belastung der Laufschicht 22 bei gleichzeitig langer Lebensdauer des Gleitlagerverbundwerkstoffs 10.

In Figur 4 ist eine schematisch dargestellte und größenmäßig nicht skalierte Schnittansicht einer erfindungsgemäßen Gleitlagerschale 42 gezeigt. Eine solche Gleitlagerschale kann aus dem erfindungsgemäßen Gleitlagerverbundwerkstoff 10 beispielsweise mittels Rollbiegen hergestellt werden.

## Patentansprüche

1. Verfahren zum Herstellen eines Gleitlagerverbundwerkstoffs (10) mit einer Stützschicht (14), insbesondere aus Stahl, mit einer Lagermetallschicht (18) aus einer bleifreien, Magnesium umfassenden Aluminiumbasislegierung und mit einer Laufschicht (22), wobei die Aluminiumbasislegierung abschließend umfasst 0,5 - 5,5 Gew.-% Magnesium, gegebenenfalls eine oder mehrere Legierungskomponenten aus der Gruppe bestehend aus Zink, Kupfer, Silizium, Eisen, Mangan, Chrom, Titan, Zirkonium, Vanadium, Nickel, Kobalt, Cer und verunreinigungsbedingte Legierungskomponenten, wobei letztere in der Summe 1 Gew.-% nicht übersteigen, und Rest Aluminium, wobei die Aluminiumbasislegierung kupferfrei ist oder höchstens 3 Gew.-% Kupfer umfasst und wobei die Aluminiumbasislegierung einen oder mehrere der nachfolgenden Legierungskomponenten aufweist 0,05 - 7,5 Gew.-% Zink, 0,05 - 6 Gew.-% Silizium, 0,05 - 0,5 Gew.-% Eisen, 0,05 - 1 Gew.-% Mangan, 0,05 - 1 Gew.-% Chrom, 0,05 - 0,5 Gew.-% Titan, 0,05 - 0,5 Gew.-% Zirkonium, 0,05 - 0,5 Gew.-% Vanadium, 0,1 - 3 Gew.-% Nickel, 0,1 - 1 Gew.-% Kobalt und/oder 0,05 - 0,5 Gew.-% Cer umfasst, und wobei ein Gesamtgehalt an Zink, Kupfer und Nickel in Summe 8 Gew.-% nicht übersteigt und ein Gesamtgehalt aller Legierungskomponenten in Summe 12 Gew.-% nicht übersteigt, wobei die Lagermetallschicht (18) entweder direkt auf die Stützschicht (14) aufgewalzt wird oder zuvor mit einer Zwischenschicht (38) aus einer Aluminiumlegierung oder aus technischem Reinaluminium walzplattiert und dann unter Zwischenordnung dieser Zwischenschicht (38) auf die Stützschicht (14) aufgewalzt wird derart, dass die Zwischenschicht (38) danach höchstens 100 µm, insbesondere höchstens 50 µm, dick ist, wobei der so erhaltene Verbund aus Stützschicht (14) und Lagermetallschicht (18) bei Temperaturen zwischen 280° - 350° Celsius für 2 bis 10 Stunden weichgeglüht wird, so dass die Lagermetallschicht des Verbunds eine Brinell-Härte von 50 - 80 HB 1/5/30 aufweist, und wobei danach die Laufschicht (22) galvanisch oder durch ein PVD-Verfahren auf die Lagermetallschicht (18) aufgebracht wird.

2. Verfahren nach Anspruch 1, **dadurch gekennzeichnet, dass** die Aluminiumbasislegierung 1,5 - 5,5 Gew.-%, insbesondere 2,0 - 5,5 Gew.-% Magnesium umfasst.

3. Verfahren nach Anspruch 1 oder 2, **dadurch gekennzeichnet, dass** die Aluminiumbasislegierung eine AlMg - Legierung mit 2-3 Gew.-% Magnesium oder -mit 3 - 4 Gew.-% Magnesium oder -mit 4 - 5 Gew.-% Magnesium ist, gegebenenfalls mit 0,15-0,35 Gew.-% Cr und/oder 0,2-0,5 Gew.-% Mn, gegebenenfalls mit weiteren Legierungskomponenten die in der Summe 1 Gew.-% nicht übersteigen, Rest Aluminium.

4. Verfahren nach einem oder mehreren der vorstehenden Ansprüche 1 bis 3, **dadurch gekennzeichnet, dass** die Laufschicht (22) eine mittels eines PVD-Verfahrens aufgebrachte Schicht ist, welche auf Al-Basis mit 5 - 40 Gew.-% Zinn ausgebildet ist und gegebenenfalls 0,1 - 5 Gew.-% Kupfer, 0,1 - 6 Gew.-% Silizium, 0,05 - 1 Gew.-% Mangan, 0,05 - 1 Gew.-% Chrom, 0,05 - 0,5 Gew.-% Titan, 0,05 - 0,5 Gew.-% Zirkonium, 0,05 - 0,5 Gew.-% Vanadium, 0,1 - 3 Gew.-% Nickel, 0,1 - 1 Gew.-% Kobalt und/oder 0,05 - 0,5 Gew.-% Cer umfasst.

5. Verfahren nach Anspruch 4, **dadurch gekennzeichnet, dass** die Laufschicht (22) von einer AlSnCu-Legierung mit 18-27 Gew.-% Zinn und mit 0,5 - 3 Gew.-% Kupfer und Rest Aluminium, insbesondere mit 20 Gew.-% Zinn und mit 1 Gew.-% Kupfer und Rest Aluminium oder mit 25 Gew.-% Zinn und mit 2,5 Gew.-% Kupfer und Rest Aluminium gebildet ist.

6. Verfahren nach Anspruch 4 oder 5, **dadurch gekennzeichnet, dass** zwischen der Laufschicht (22) und der Lagermetallschicht (18) eine weitere mittels eines PVD-Verfahrens aufgebrachte Schicht (34) aus einer Aluminiumbasislegierung oder einer Kupfer-, Kobalt- oder Nickelbasislegierung angeordnet ist.

7. Verfahren nach einem oder mehreren der vorstehenden Ansprüche 1 bis 4, **dadurch gekennzeichnet, dass** die Laufschicht (22) eine galvanisch abgeschiedene Schicht aus Wismut oder einer Wismutlegierung oder aus Zinn oder einer Zinn-Kupfer-Legierung, insbesondere mit 4 - 8 Gew.-% Kupfer, insbesondere mit 6 -Gew.-% Kupfer, Rest Zinn, ist.

8. Verfahren nach Anspruch 7, **dadurch gekennzeichnet, dass** zwischen der Laufschicht (22) und der Lagermetallschicht (18) eine erste Zwischenschicht (26) auf Nickel- oder Kupfer- oder Kobalt-Basis angeordnet ist.

9. Verfahren nach Anspruch 8, **dadurch gekennzeichnet, dass** zwischen der Laufschicht (22) und der ersten Zwischenschicht (26) eine zweite Zwischenschicht (30) auf Zinn-Nickel-Basis oder Zinn-Kupfer-Basis oder Zinn-Kobalt-Basis angeordnet ist.

10. Verfahren nach einem oder mehreren der vorstehenden Ansprüche, **dadurch gekennzeichnet, dass** die Dicke der Laufschicht (22) höchstens 30 µm, insbesondere höchstens 25 µm, insbesondere höchstens 20 µm, und wenigstens 5 µm, insbesondere wenigstens 10 µm, insbesondere 10 - 20 µm beträgt.

11. Gleitlagerverbundwerkstoff (10) hergestellt nach einem Verfahren nach einem oder mehreren der vorstehenden Ansprüche, mit einer Stützschicht (14), insbesondere aus Stahl, mit einer Lagermetallschicht (18) aus einer bleifreien, Magnesium umfassenden Aluminiumbasislegierung und mit einer Laufschicht (22), wobei die Aluminiumbasislegierung 0,5 - 5,5 Gew.-% Magnesium umfasst und gegebenenfalls eine oder mehrere Legierungskomponenten aus der Gruppe bestehend aus Zink, Kupfer, Silizium, Eisen, Mangan, Chrom, Titan, Zirkonium, Vanadium, Nickel, Kobalt, Cer und verunreinigungsbedingten Legierungskomponenten umfasst, wobei letztere in der Summe 1 Gew.-% nicht übersteigen, und wobei die Aluminiumbasislegierung kupferfrei ist oder höchstens 3 Gew.-% Kupfer umfasst, und wobei die Aluminiumbasislegierung einen oder mehrere der nachfolgenden Legierungskomponenten aufweist 0,05 - 7,5 Gew.-% Zink, 0,05 - 6 Gew.-% Silizium, 0,05 - 0,5 Gew.-% Eisen, 0,05 - 1 Gew.-% Mangan, 0,05 - 1 Gew.-% Chrom, 0,05 - 0,5 Gew.-% Titan, 0,05 - 0,5 Gew.-% Zirkonium, 0,05 - 0,5 Gew.-% Vanadium, 0,1 - 3 Gew.-% Nickel, 0,1 - 1 Gew.-% Kobalt und/oder 0,05 - 0,5 Gew.-% Cer umfasst, und wobei ein Gesamtgehalt an Zink, Kupfer und Nickel in Summe 8 Gew.-% nicht übersteigt und ein Gesamtgehalt aller Legierungskomponenten in Summe 12 Gew.-% nicht übersteigt, wobei die Lagermetallschicht (18) entweder direkt oder unter Zwischenordnung einer höchstens 100 µm, insbesondere höchstens 50 µm dicken Zwischenschicht (38) aus einer Aluminiumlegierung oder aus technischem Reinaluminium auf die Stützschicht (14) aufgewalzt ist, wobei der so erhaltene Verbund aus Stützschicht (14) und Lagermetallschicht (18) bei Temperaturen zwischen 280° - 350° Celsius für 2 bis 10 Stunden weichgeglüht ist, so dass die Lagermetallschicht des Verbunds eine Brinell-Härte von 50 - 80 HB 1/5/30 aufweist, und wobei danach die Laufschicht (22) galvanisch oder durch ein PVD-Verfahren auf die Lagermetallschicht (18) aufgebracht ist.

12. Gleitlagerelement (42), insbesondere Gleitlagerschale, insbesondere Kurbelwellenlagerschale oder Pleuellagerschale, **dadurch gekennzeichnet, dass** es einen Gleitlagerverbundwerkstoff (10) nach Anspruch 11 umfasst.

## Claims

1. A method for producing a slide bearing composite material (10) having a supporting layer (14), in particular of steel, having a bearing-metal layer (18) of a lead-free aluminum-based alloy that includes magnesium, and having a sliding layer (22), wherein the aluminum-based alloy finally includes 0.5 - 5.5 weight % magnesium, optionally one or more alloy components from the group comprising zinc, copper, silicon, iron, manganese, chromium, titanium, zirconium, vanadium, nickel, cobalt, cerium and contamination-dictated alloy components, wherein the latter in total does not exceed 1 weight %, the remainder being aluminum, and wherein the aluminum-based alloy is copper-free or includes at most 3 weight % copper, and the aluminum-based alloy has one or more of the following alloy components: 0.05 - 7.5 weight % zinc, 0.05 - 6 weight % silicon, 0.05 - 0.5 weight % iron, 0.05 - 1 weight % manganese, 0.05 - 1 weight % chromium, 0.05 - 0.5 weight % titanium, 0.05 - 0.5 weight % zirconium, 0.05 - 0.5 weight % vanadium, 0.1 - 3 weight % nickel, 0.1 - 1 weight % cobalt, and/or 0.05 - 0.5 weight % cerium, and wherein a total content of zinc, copper and nickel does not exceed a total of 8 weight % and a total content of all the alloy components does not exceed a total of 12 weight %, wherein the bearing-metal layer (18) is either rolled directly onto the supporting layer (14) or is roller-plated beforehand with an intermediate layer (38) of an aluminum alloy or of technical pure aluminum and then, with the interposition of this intermediate layer (38), is rolled onto the supporting layer (14), in such a way that the intermediate layer (38) afterward is at most 100 µm and in particular at most 50 µm thick, wherein the thus-obtained composite of the supporting layer (14) and the bearing-metal layer (18) is soft-annealed for 2 to 10 hours at temperatures between 280° - 350° Celsius, so that the bearing-metal layer of the composite has a Brinell hardness of 50 - 80 HB 1/5/30, and wherein after that the sliding layer (22) is applied galvanically or by a PVD process to the bearing-metal layer (18).

2. The method of claim 1, **characterized in that** the aluminum-based alloy includes 1.5 - 5.5 weight %, and in particular 2.0 - 5.5 weight %, of magnesium.

3. The method of claim 1 or 2, **characterized in that** the aluminum-based alloy is an AlMg-alloy having 2 - 3 weight % magnesium or having 3 - 4 weight % magnesium or having 4 - 5 weight % magnesium, optionally having 0.15 - 0.35 weight % Cr and/or 0.2 - 0.5 weight % Mn, optionally having further alloy components which do not exceed a total of 1 weight %, the remainder being aluminum.

4. The method of one or more of the foregoing claims 1 through 3, **characterized in that** the sliding layer (22) is a layer applied by means of a PVD process, which layer is embodied on an aluminum base having 5 - 40 weight % tin and optionally 0.1 - 5 weight % copper, 0.1 - 6 weight % silicon, 0.05 - 1 weight % manganese, 0.05 - 1 weight % chromium, 0.05 - 0.5 weight % titanium, 0.05 - 0.5 weight % zirconium, 0.05 - 0.5 weight % vanadium, 0.1 - 3 weight % nickel, 0.1 - 1 weight % cobalt and/or 0.05 - 0.5 weight % cerium.

5. The method of claim 4, **characterized in that** the sliding layer (22) is formed of an AlSnCu alloy having 18 - 27 weight % tin and having 0.5 - 3 weight % copper and the remainder being aluminum, in particular having 20 weight % tin and having 1 weight % copper and the remainder being aluminum, or having 25 weight % tin and having 2.5 weight % copper and the remainder being aluminum.

6. The method of claim 4 or 5, **characterized in that** a further layer (43), applied by means of a PVD process, comprising an aluminum-based alloy or a copper-, cobalt-or nickel-based alloy is located between the sliding layer (22) and the bearing-metal layer (18).

7. The method of one or more of the foregoing claims 1 through 4, **characterized in that** the sliding layer (22) is a galvanically deposited layer of bismuth or of a bismuth alloy or of tin or of a tin-copper alloy, in particular having 4 - 8 weight % copper, in particular having 6 weight % copper, the remainder being tin.

8. The method of claim 7, **characterized in that** a first intermediate layer (26) on a nickel or copper or cobalt base is located between the sliding layer (22) and the bearing-metal layer (18).

9. The method of claim 8, **characterized in that** a second intermediate layer (30) on a tin-nickel base or tin-copper base or tin-cobalt base is located between the sliding layer (22) and the first intermediate layer (26).

10. The method of one or more of the foregoing claims, **characterized in that** the thickness of the sliding layer (22) amounts at most to 30 µm, in particular at most 25 µm, in particular at most 20 µm, and at least 5 µm, in particular at least 10 µm, in particular 10 - 20 µm.

11. A slide bearing composite material (10), produced by a method of one or more of the foregoing claims, having a supporting layer (14), in particular of steel, having a bearing-metal layer (18) of a lead-free aluminum-based alloy that includes magnesium, and having a sliding layer (22), wherein the aluminum-based alloy finally includes 0.5 - 5.5 weight % magnesium, optionally one or more alloy components from the group comprising zinc, copper, silicon, iron, manganese, chromium, titanium, zirconium, vanadium, nickel, cobalt, cerium and contamination-dictated alloy components, wherein the latter in total does not exceed 1 weight %, and wherein the aluminum-based alloy is copper-free or includes at most 3 weight % copper, and the aluminum-based alloy has one or more of the following alloy components: 0.05 - 7.5 weight % zinc, 0.05 - 6 weight % silicon, 0.05 - 0.5 weight % iron, 0.05 - 1 weight % manganese, 0.05 - 1 weight % chromium, 0.05 - 0.5 weight % titanium, 0.05 - 0.5 weight % zirconium, 0.05 - 0.5 weight % vanadium, 0.1 - 3 weight % nickel, 0.1 - 1 weight % cobalt, and/or 0.05 - 0.5 weight % cerium, and wherein a total content of zinc, copper and nickel does not exceed a total of 8 weight % and a total content of all the alloy components does not exceed a total of 12 weight %, wherein the bearing-metal layer (18) is either rolled directly or with the interposition of an intermediate layer (38), at most 100 µm, in particular at most 50 µm thick, of an aluminum alloy or technical pure aluminum onto the supporting layer (14), wherein the thus-obtained composite of the supporting layer (14) and the bearing-metal layer (18) is soft-annealed for 2 to 10 hours at temperatures between 280° - 350° Celsius, so that the bearing-metal layer of the composite has a Brinell hardness of 50 - 80 HB 1/5/30, and wherein after that the sliding layer (22) is applied galvanically or by a PVD process to the bearing-metal layer (18).

12. A slide bearing element (42), in particular a slide bearing shell, in particular a crankshaft bearing shell or connecting rod bearing shell, **characterized in that** it includes a slide bearing composite material (10) of claim 11.

## Revendications

1. Procédé de fabrication d'un matériau composite pour palier lisse (10) comprenant une couche de support (14), en particulier en acier, une couche de métal antifriction (18) en un alliage de base d'aluminium exempt de plomb et comprenant du magnésium, ainsi qu'une couche de roulement (22), dans lequel ledit alliage de base d'aluminium comprend finalement entre 0,5 et 5,5 % en poids de magnésium, le cas échéant un ou plusieurs composants d'alliage choisis dans le groupe constitué par le zinc, le cuivre, le silicium, le fer, le manganèse, le chrome, le titane, le zirconium, le vanadium, le nickel, le cobalt, le cérium et des composants d'alliage dus aux impuretés, ces derniers ne dépassant pas au total 1 % en poids, et le reste d'aluminium, dans lequel ledit alliage de base d'aluminium est exempt de cuivre ou comprend tout au plus 3 % en poids de cuivre et dans lequel ledit alliage de base d'aluminium présente un ou plusieurs des composants d'alliage suivants: entre 0,05 et 7,5 % en poids de zinc, entre 0,05 et 6 % en poids de silicium, entre 0,05 et 0,5 % en poids de fer, entre 0,05 et 1 % en poids de manganèse, entre 0,05 et 1 % en poids de chrome, entre 0,05 et 0,5 % en poids de titane, entre 0,05 et 0,5 % en poids de zirconium, entre 0,05 et 0,5 % en poids de vanadium, entre 0,1 et 3 % en poids de nickel, entre 0,1 et 1 % en poids de cobalt et/ou entre 0,05 et 0,5 % en poids de cérium, et dans lequel une teneur totale en zinc, cuivre et nickel ne dépasse pas au total 8 % en poids, et une teneur totale de tous les composants d'alliage ne dépasse pas au total 12 % en poids, dans lequel la couche de métal antifriction (18) soit est appliquée par laminage directement sur la couche de support (14) soit est d'abord plaquée par laminage d'une couche intermédiaire (38) en un alliage d'aluminium ou en aluminium pur technique et, puis, est appliquée par laminage, avec interposition de cette couche intermédiaire (38), sur la couche de support (14) de telle sorte que, ensuite, la couche intermédiaire (38) présente une épaisseur de 100 µm tout au plus, en particulier de 50 µm tout au plus, dans lequel le composite ainsi obtenu constitué par la couche de support (14) et la couche de métal antifriction (18) est soumis à un recuit à des températures comprises entre 280° et 350° Celsius pendant 2 à 10 heures de sorte que la couche de métal antifriction du composite présente une dureté Brinell comprise entre 50 et 80 HB 1/5/30, et dans lequel, ensuite, la couche de roulement (22) est appliquée de façon galvanique ou par un procédé PVD sur la couche de métal antifriction (18).

2. Procédé selon la revendication 1, **caractérisé par le fait que** ledit alliage de base d'aluminium comprend entre 1,5 et 5,5 % en poids, en particulier entre 2,0 et 5,5 % en poids de magnésium.

3. Procédé selon la revendication 1 ou 2, **caractérisé par le fait que** ledit alliage de base d'aluminium est un alliage AlMg comprenant entre 2 et 3 % en poids de magnésium ou entre 3 et 4 % en poids de magnésium ou entre 4 et 5 % en poids de magnésium, le cas échéant entre 0,15 et 0,35 % en poids de Cr et/ou entre 0,2 et 0,5 % en poids de Mn, le cas échéant d'autres composants d'alliage qui ne dépassent pas au total 1 % en poids, le reste d'aluminium.

4. Procédé selon l'une ou plusieurs des revendications précédentes 1 à 3, **caractérisé par le fait que** la couche de roulement (22) est une couche appliquée au moyen d'un procédé PVD qui est réalisée à base d'Al comprenant entre 5 et 40 % en poids d'étain et qui comprend le cas échéant entre 0,1 et 5 % en poids de cuivre, entre 0,1 et 6 % en poids de silicium, entre 0,05 et 1 % en poids de manganèse, entre 0,05 et 1 % en poids de chrome, entre 0,05 et 0,5 % en poids de titane, entre 0,05 et 0,5 % en poids de zirconium, entre 0,05 et 0,5 % en poids de vanadium, entre 0,1 et 3 % en poids de nickel, entre 0,1 et 1 % en poids de cobalt et/ou entre 0,05 et 0,5 % en poids de cérium.

5. Procédé selon la revendication 4, **caractérisé par le fait que** la couche de roulement (22) est constituée par un alliage AlSnCu comprenant entre 18 et 27 % en poids d'étain et entre 0,5 et 3 % en poids de cuivre et le reste d'aluminium, en particulier 20 % en poids d'étain et 1 % en poids de cuivre et le reste d'aluminium, ou 25 % en poids d'étain et 2,5 % en poids de cuivre et le reste d'aluminium.

6. Procédé selon la revendication 4 ou 5, **caractérisé par le fait qu'**une autre couche (34) en un alliage de base d'aluminium ou en un alliage de base de cuivre, de cobalt ou de nickel, appliquée au moyen d'un procédé PVD, est disposée entre ladite couche de roulement (22) et ladite couche de métal antifriction (18).

7. Procédé selon l'une ou plusieurs des revendications précédentes 1 à 4, **caractérisé par le fait que** la couche de roulement (22) est une couche, déposée de façon galvanique, en bismuth ou en un alliage de bismuth ou en étain ou en un alliage d'étain et de cuivre, en particulier ayant entre 4 et 8 % en poids de cuivre, en particulier 6 % en poids de cuivre, le reste d'étain.

8. Procédé selon la revendication 7, **caractérisé par le fait qu'**une première couche intermédiaire (26) à base de nickel ou de cuivre ou de cobalt est disposée entre la couche de roulement (22) et la couche de métal antifriction (18).

9. Procédé selon la revendication 8, **caractérisé par le fait qu'**une deuxième couche intermédiaire (30) à base d'étain et de nickel ou à base d'étain et de cuivre ou à base d'étain et de cobalt est disposée entre la couche de roulement (22) et la première couche intermédiaire (26).

10. Procédé selon l'une ou plusieurs des revendications précédentes, **caractérisé par le fait que** l'épaisseur de la couche de roulement (22) est de 30 µm tout au plus, en particulier de 25 µm tout au plus, en particulier de 20 µm tout au plus, et de 5 µm au moins, en particulier de 10 µm au moins, en particulier comprise entre 10 et 20 µm.

11. Matériau composite pour palier lisse (10) fabriqué selon un procédé selon l'une ou plusieurs des revendications précédentes, comprenant une couche de support (14), en particulier en acier, une couche de métal antifriction (18) en un alliage de base d'aluminium exempt de plomb et comprenant du magnésium, ainsi qu'une couche de roulement (22), dans lequel ledit alliage de base d'aluminium comprend entre 0,5 et 5,5 % en poids de magnésium et le cas échéant un ou plusieurs composants d'alliage choisis dans le groupe constitué par le zinc, le cuivre, le silicium, le fer, le manganèse, le chrome, le titane, le zirconium, le vanadium, le nickel, le cobalt, le cérium et des composants d'alliage dus aux impuretés, ces derniers ne dépassant pas au total 1 % en poids, et dans lequel ledit alliage de base d'aluminium est exempt de cuivre ou comprend tout au plus 3 % en poids de cuivre et dans lequel ledit alliage de base d'aluminium présente un ou plusieurs des composants d'alliage suivants: entre 0,05 et 7,5 % en poids de zinc, entre 0,05 et 6 % en poids de silicium, entre 0,05 et 0,5 % en poids de fer, entre 0,05 et 1 % en poids de manganèse, entre 0,05 et 1 % en poids de chrome, entre 0,05 et 0,5 % en poids de titane, entre 0,05 et 0,5 % en poids de zirconium, entre 0,05 et 0,5 % en poids de vanadium, entre 0,1 et 3 % en poids de nickel, entre 0,1 et 1 % en poids de cobalt et/ou entre 0,05 et 0,5 % en poids de cérium, et dans lequel une teneur totale en zinc, cuivre et nickel ne dépasse pas au total 8 % en poids, et une teneur totale de tous les composants d'alliage ne dépasse pas au total 12 % en poids, dans lequel la couche de métal antifriction (18) est appliquée par laminage soit directement sur la couche de support (14) soit avec interposition d'une couche intermédiaire (38) en un alliage d'aluminium ou en aluminium pur technique présentant une épaisseur de 100 µm tout au plus, en particulier de 50 µm tout au plus, dans lequel le composite ainsi obtenu constitué par la couche de support (14) et la couche de métal antifriction (18) est soumis à un recuit à des températures comprises entre 280° et 350°Celsius pendant 2 à 10 heures de sorte que la couche de métal antifriction du composite présente une dureté Brinell comprise entre 50 et 80 HB 1/5/30, et dans lequel, ensuite, la couche de roulement (22) est appliquée de façon galvanique ou par un procédé PVD sur la couche de métal antifriction (18).

12. Elément de palier lisse (42), en particulier coussinet de palier lisse, en particulier coussinet de vilebrequin ou coussinet de bielle, **caractérisé par le fait qu'**il comprend un matériau composite pour palier lisse (10) selon la revendication 11.
